# Europäisches Patentamt
# European Patent Office
# Office européen des brevets

(19)

(11) Publication number: **0 035 345**
**B1**

(12)

# EUROPEAN PATENT SPECIFICATION

(45) Date of publication of patent specification: **13.07.83**

(51) Int. Cl.³: **H 03 K 17/22, G 06 F 1/00**

(21) Application number: **81300666.5**

(22) Date of filing: **18.02.81**

(54) A power-on reset circuit.

(30) Priority: **29.02.80 JP 24746/80**

(43) Date of publication of application:
**09.09.81 Bulletin 81/36**

(45) Publication of the grant of the patent:
**13.07.83 Bulletin 83/28**

(84) Designated Contracting States:
**DE FR GB**

(56) References cited:
**US - A - 4 210 829**

**Patents Abstracts of Japan, Vol. 4, No. 67, 20 May 1980 page 12E11**

**ELECTRONIC ENGINEERING, Vol. 51, No. 627, September 1979 W. F. CLARK "Power-On Reset/run Circuits for the CDP1802uP" page 25**

(73) Proprietor: **FUJITSU LIMITED**
**1015, Kamikodanaka Nakahara-ku**
**Kawasaki-shi Kanagawa 211 (JP)**

(72) Inventor: **Monma, Hideo**
**Co-op Suzuki 201-52, Suge Tama-ku**
**Kawasaki-shi Kanagawa 214 (JP)**
Inventor: **Takahashi, Masayuki**
**6-22, Suehiro 1-chome**
**Utsunomiya-shi Tochigi 321-01 (JP)**

(74) Representative: **Rackham, Stephen Neil et al,**
**GILL JENNINGS & EVERY 53-64 Chancery Lane**
**London WC2A 1HN (GB)**

# A power-on reset circuit

The present invention relates to a power-on reset circuit, and particularly to a reset circuit which resets internal circuits of a semiconductor device initially when an operating voltage is supplied to the semiconductor device.

In general, a semiconductor device, such as a micro-processor, formed on a semiconductor chip includes a power-on reset circuit which initially resets the internal circuits of the semiconductor chip automatically when an operating voltage is switched on to the semiconductor chip, to set the internal circuits to a predetermined initial condition.

A power supply to a conventional semiconductor device includes an integrating circuit to prevent the generation of current surges. As a result of this the power supply to components forming part of the device builds up gradually. Equally, the potential supplied to the clear signal terminal of the conventional power-on reset circuit also builds up gradually. In a conventional device the reset output is emitted from the reset circuit before the voltage on the clear signal terminal reaches a threshold value. When the voltage applied to the clear signal terminal and the power supply to the power-on reset circuit build up at a similar rate it is possible for errors to occur in the delivery of the reset signal because there is insufficient delay between the powering up of the power-on reset circuit and the attainment of the threshold value on the clear signal terminal. Attempts have been made to prevent this by increasing the capacitance connected to the clear signal terminal or by increasing the resistance of the path leading to the clear signal terminal. Neither of these have been successful as will be explained in more detail subsequently.

According to this invention a power-on reset circuit to reset internal circuits in a semiconductor device initially after an operating voltage is switched on,

comprises an operating voltage terminal for the internal circuits, a capacitor, detector means for detecting a potential of one of the terminals of the capacitor and sending a reset signal to the internal circuits until the potential reaches a predetermined value after the operating voltage is switched on to the operating voltage terminal, and a resistance circuit connected between the one of the terminals of the capacitor and the operating voltage terminal of the internal circuits, and is characterised in that the resistance value of the resistance circuit decreases after the potential of the one of the terminals of the capacitor has reached the predetermined value.

The circuit in accordance with this invention operates effectively even when the potential of the operating voltage rises slowly. Moreover, the circuit is not affected by noise induced in the power-on reset circuit and also it does not occupy a large space on a semiconductor chip.

Three examples of a circuit in accordance with this invention will now be described and contrasted with those used previously with reference to the accompanying drawings; in which:—

Figures 1A and 1B are circuit diagrams of conventional power-on reset circuits;

Figures 2A and 2B are graphs illustrating the operation of the conventional power-on reset circuits;

Figure 3 is a circuit diagram of a first example of the present invention;

Figure 4 is a graph illustrating the operation of the first example;

Figure 5 is a circuit diagram of a second example of the present invention;

Figure 6 is a graph illustrating the operation of the second example; and

Figure 7 is a circuit diagram of a third example of the present invention.

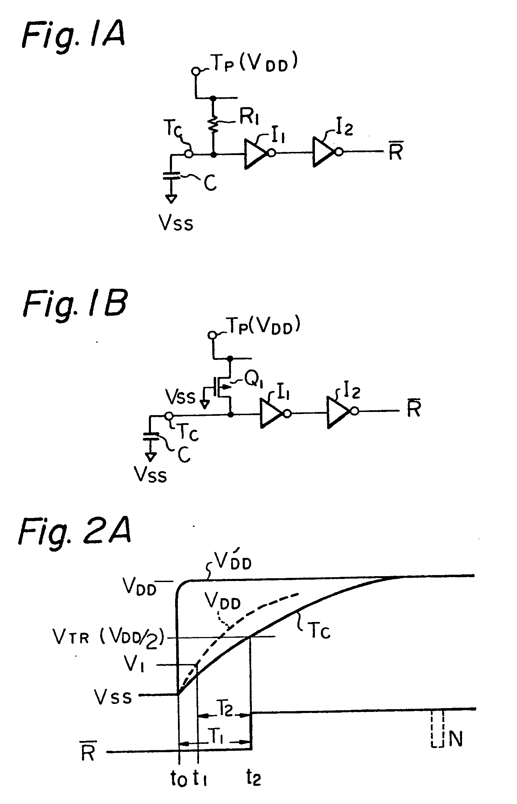

Figures 1A and 1B illustrate conventional power-on reset circuits used in a semiconductor device. C is a capacitor which is usually disposed outside the semiconductor device and is connected between a clear signal terminal Tc of the semiconductor device and a low voltage source $V_{ss}$, for example, the ground whose potential is O V. $I_1$ and $I_2$ are two stage inverters and an output signal $\overline{R}$ from the second inverter $I_2$ is used as a reset signal $\overline{R}$ supplied to the internal circuits of the semi-conductor device. In Figure 1A, a resistor $R_1$ is connected between the clear signal terminal Tc and an operating voltage terminal Tp of the semiconductor device, the terminal Tp being connected to an operating voltage $V_{DD}$. The resistor $R_1$ and the capacitor C make up an integrating circuit whose time constant is $CR_1$. In Figure 1B, the resistor $R_1$ shown in Figure 1A is replaced by a p-channel MOS transistor $Q_1$ whose gate electrode is connected to the low potential voltage $V_{ss}$ and whose source and drain electrodes are connected to the operating voltage terminal Tp and the clear signal terminal Tc, respectively.

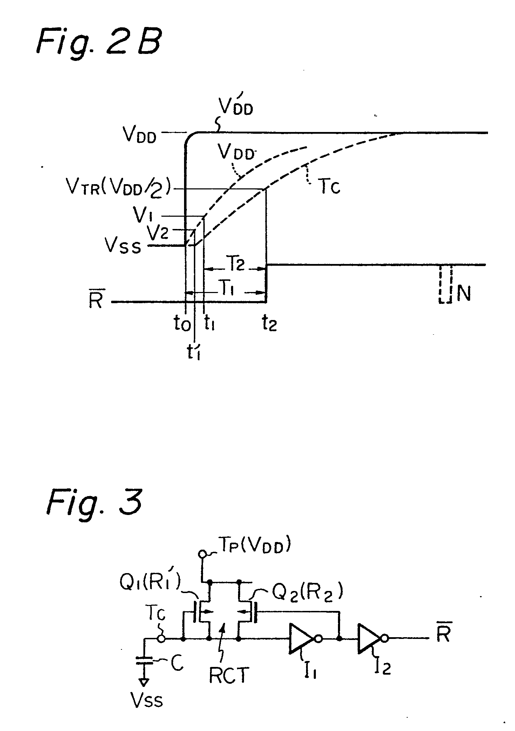

Figures 2A and 2B illustrate the operation of the conventional power-on reset circuits. In the circuit shown in Figure 1A, when an operating voltage $V_{DD}$ is switched on to the operating voltage terminal Tp, the capacitor C is gradually charged up to the operating voltage $V_{DD}$ through the resistor $R_1$ and the potential of the clear signal terminal Tc rises as shown in Figure 2A. When the potential of the terminal Tc reaches a threshold potential $V_{TR}$ of the first inverter $I_1$, i.e., at the time $t_2$, an output potential of the inverter $I_1$ changes from high to low so that the output potential of the second inverter $I_2$, i.e. the reset signal $\overline{R}$ changes from low to high. Assuming that the reset of the internal circuits connected to the power-on reset circuit shown in Figure 1A occurs when the potential of the reset signal $\bar{R}$ is low, then the reset of the internal circuits is effected within a time period $T_1$ between a power-on time $t_0$ and the time $t_2$, more particularly after the operating voltage $V_{DD}$ has risen enough to operate the internal circuits and within the time period $T_2$. If the potential of the operating voltage $V_{DD}$ rises rapidly as shown by a solid line $V'_{DD}$, the reset of the internal circuits occurs within the time period $T_1$. However, if the potential of the operating voltage $V_{DD}$ rises gradually as shown by the dotted line $V_{DD}$ the reset occurs within a time period $T_2$ between a time $t_1$ when the potential of the operating voltage $V_{DD}$ has reached a minimum potential voltage $V_1$ enough to operate the internal circuits and the aforementioned time $t_2$.

With regard to the power-on reset circuit shown in Figure 1B, the operation is the same as that of the power-on reset circuit shown in Figure 1A, except that the potential of the clear signal terminal Tc starts to rise from O V at a time $t'_1$ as shown in the dotted line (Tc) when the potential of the operating voltage $V_{DD}$ rises gradually as shown by the dotted line $V_{DD}$. The time $t'_1$ is the time when the potential of operating voltage $V_{DD}$ has reached a threshold voltage $V_2$ of the transistor $Q_1$ so that the transistor $Q_1$ is turned on. When the potential of the operating voltage $V_{DD}$ rises rapidly as shown by the solid line $V_{DD'}$, the potential of the clear signal terminal Tc rises in approximately the same manner as shown by the solid line Tc. In the power-on reset circuit shown in Figure 1B, the reset of the internal circuits also occurs within the time period $T_1$ when the potential of the operating voltage $V_{DD}$ rises rapidly as shown in the solid line $V_{DD'}$, or within the time period $T_2$ when the potential of the operating voltage $V_{DD}$ rises gradually as shown in the dotted line $V_{DD}$.

However, the operating voltage for an integrated circuit formed on a semiconductor chip is usually supplied through an integrating circuit to a power supply terminal of the integrated circuit in order to avoid destruction of the integrated circuit by a surge current. Therefore, the potential of the operating voltage terminal Tp usually rises slowly as shown by the dotted, lines $V_{DD}$, and the time interval between the power-on time $t_0$ and the time $t_1$ when the potential of the operating voltage terminal Tp reaches $V_1$ becomes long, so that the time interval $T_2$ within which the reset of the internal circuits of the semiconductor device has to occur is reduced. The time interval $T_2$ becomes shorter and shorter in accordance with the increase of the rise time of the potential of the operating voltage terminal Tp. If the potential of the operating voltage terminal Tp rises very slowly, the potential of the clear signal terminal Tc rises almost in the same manner as the potential of the operating voltage terminal Tp. Therefore, in the worst case, there is a possibility of failure of the reset of the internal circuits due to an extreme decrease in the time interval $T_2$. Especially in a semiconductor device whose operating voltage is relatively low, the operating speed of the internal circuits of the semiconductor device is low, so that the probability of the failure of the reset of the internal circuits is large.

To solve this problem, the time $t_2$ when the potential of the reset signal $\bar{R}$ changes from low to high is delayed by increasing the time constant $CR_1$. The time constant $CR_1$ can be increased by increasing the capacitance of the capacitor C or by increasing the resistance of the resistor $R_1$ or of the main current path of the transistor $Q_1$.

However, to increase the capacity of the capacitor C, it is necessary to increase the size of the capacitor C, so that the capacitor C then occupies a larger space. Therefore, it is difficult to use the power-on reset circuit when the space is limited. Moreover, enlarging the capacity which necessitates an increase in the size of the capacitor C, leads to an increase in the cost of the power-on reset circuit.

With regard to the increase in the resistance of the resistor $R_1$ or the drain source resistance of the transistor $Q_1$, for example, to a value of about one megaohm, there occurs a problem that the internal circuit is reset by a noise pulse induced in the clear signal terminal Tc of the power-on reset circuit. This is because the resistor $R_1$ or the drain source resistance of the transistor $Q_1$ is a pull-up resistor which holds the potential of the clear signal terminal Tc high, during a steady state operation of the internal circuit, and if the resistance of the pull-up resistor is too large, its pull-up operation is not effected completely. For example, when a noise pulse of negative polarity is induced to the clear signal terminal Tc during the steady state operation and positive charges of the capacitor C are discharged, the capacitor C cannot be recharged immediately through the resistor $R_1$, because the resistance of the resistor $R_1$ is large. Therefore, the reset signal $\bar{R}$ from the second inverter $I_2$ includes a negative pulse N as illustrated by a dotted line in Figures 2A and 2B, so that an undesirable reset pulse is generated.

Figure 3 illustrates a first example of a power-on reset circuit in accordance with the present invention.

The power-on reset circuit shown in Figure 3 comprises a capacitor C, a resistance circuit RCT consisting of p-channel MOS transistors $Q_1$ and $Q_2$, a first inverter $I_1$ and a second inverter $I_2$. The capacitor C is connected between a low voltage source $V_{ss}$, for example the ground, and a clear signal terminal Tc which is connected to the input of the first inverter $I_1$. The source electrodes of the transistors $Q_1$ and $Q_2$ are commonly connected to an operating voltage terminal Tp, to which an operating voltage $V_{DD}$ is connected. The drain electrodes of the transistors $Q_1$ and $Q_2$ are commonly connected to the clear signal terminal Tc. The gate electrode of the transistor $Q_1$ is connected to the drain electrode of the same transistor $Q_1$, i.e. to the clear signal terminal Tc. The gate electrode of the transistor $Q_2$ is connected to the output of the first inverter $I_1$ which is connected to the input of the second inverter $I_2$. The output signal from the second inverter $I_2$ is supplied to internal circuits of a semi-conductor chip, (not shown in Figure 3) as a reset signal $\bar{R}$. Therefore, the power-on reset circuit of Fig. 3 is the same as that of Fig. 1A, except that the resistor $R_1$ of Fig. 1A is replaced by the resistance circuit RCT.

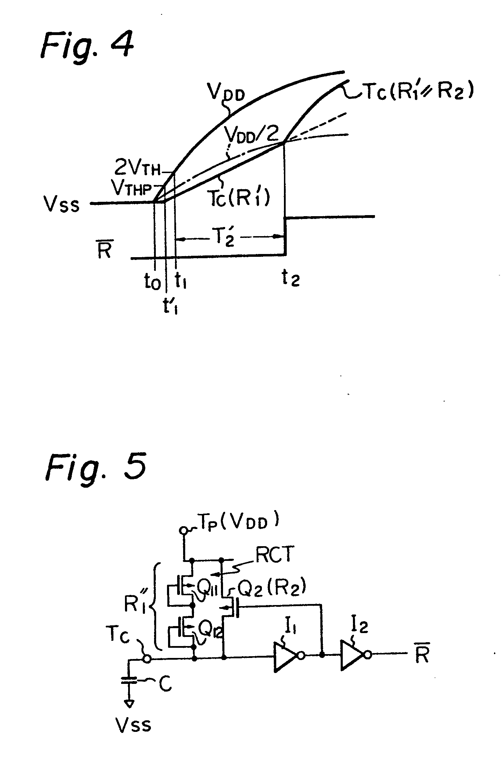

With reference to Fig. 4, operation of the power-on reset circuit of Fig. 3 will now be explained. Assume that the potential of the operating voltage $V_{DD}$ starts to rise from the time $t_0$ of Fig. 4. In this condition, the potential of the clear signal terminal $T_c$ does not change and is equal to $V_{ss}$ until the time $t_1'$ when the potential of the operating voltage $V_{DD}$ becomes equal to the threshold voltage $V_{THP}$ of the p-channel transistor Q1. At the time $t = t_1'$, the transistor $Q_1$ is turned on and the potential of the clear signal terminal $T_c$ starts to rise gradually with a time constant $CR_1'$ toward the potential of the operating voltage $V_{DD}$, where $R_1'$ is the resistance of the main current path of the transistor $Q_1$. Since the gate electrode of the transistor $Q_1$ is connected to the drain electrode of the same transistor $Q_1$, i.e., to the clear signal terminal $T_c$, the resistance $R_1'$, therefore, the time constant $CR_1'$ varies according to the potential rise of the clear signal terminal $T_c$. It should be noted that the gate electrode of the transistor $Q_1$ can be connected to the low voltage source $V_{ss}$, or the transistor $Q_1$ used as the first resistance element whose resistance is always high can be replaced by a resistor $R_1$ having a constant resistance as used in the power-on reset circuit of Fig. 1A.

At the time $t = t_2$ when the potential of the clear signal terminal $T_c$ is equal to the threshold voltage of the first inverter $I_1$, for example $V_{DD}/2$ as shown by the chain line in Fig. 4, the potential of the output signal from the first inverter $I_1$ changes from high to low and thus the reset signal $\bar{R}$ from the second inverter $I_2$ changes from low level to high level, so that the transistor $Q_2$ is turned on. Since the transistor $Q_2$, which operates as the second resistance element, receives the output signal from the first inverter $I_4$ at the gate electrode thereof, the transistor $Q_2$ is in the turned off condition when the reset signal $\bar{R}$ is low and the output signal from the first inverter $I_1$ is high. When the reset signal $\bar{R}$ becomes high and the transistor $Q_2$ is turned on as mentioned above, the resistance the source-drain path, i.e., the main current path of the transistor $Q_2$ is equal to the low resistance value $R_2$. Therefore, after the time $t = t_2$, a combined resistance value of the resistance circuit RCT decreases and becomes $R_1'//R_2$, where $R_1'//R_2$ designates a resistance value of a parallel connection of the resistance

$R_1'$ and the resistance $R_2$, so that the potential of the clear signal terminal $T_c$ rises rapidly toward $V_{DD}$ with a time constant $CR_1 R_2/(R_1 + R_2)$. The reset of the internal circuits of the semiconductor chip, not shown in Fig. 3, is effected within a time period when the reset signal $\bar{R}$ is low, and more particularly within a time period $T_2'$ from the time $t_1$ when the potential of the operating voltage $V_{DD}$ reaches a minimum operating voltage of the internal circuits, corresponding to $V_1$ of Fig. 2A or 2B, to the time $t_2$. The minimum operating voltage of the internal circuits is equal to $2V_{TH}$, when the internal circuits consists of C—MOS circuits and minimum operating voltages of a p-channel MOS transistor and a n-channel MOS transistor are both approximately equal to $V_{TH}$.

The time period $T_2'$ can be elongated by increasing the resistance $R_1'$ even when the capacitance of the capacitor C is not increased or when it is decreased. Therefore, the reset or clear of the internal circuits is perfectly effected by the power-on reset circuit of Fig. 3.

After the time $t = t_2$, the reset of the internal circuits is not necessary and generally are not effected. In the power-on reset circuit of Fig. 3, the resistance $R_1'//R_2$ of the resistance circuit RCT becomes very small compared with the resistance $R_1'$ of the main current path of the transistor $Q_1$. Therefore, even if the positive charges of the capacitor C are discharged by the noises having a negative polarity, the capacitor C is rapidly charged again and, therefore, the potential of the clear signal terminal $T_c$ is almost constant, so that the potential of the clear signal terminal $T_c$ is tightly pulled up. In order to decrease the turned-on resistance $R_2$ of the transistor $Q_2$, for example the channel width of the transistor $Q_2$ is made larger than that of the transistor $Q_1$. In the power-on reset circuit of Fig. 3, the undesirable reset due to the temporary decrease of the potential of the clear signal terminal $T_c$ in the steady state operation is prevented, even if the noise pulses of negative polarity are induced to the terminal $T_c$ from a noise source, for example, an automobile engine.

Fig. 5 illustrates another power-on reset circuit as the second embodiment of the present invention. The power-on reset circuit of Fig. 5 is the same as that of Fig. 3, except that the first resistance element of the resistance circuit RCT consists of a series connection of two p-channel MOS transistors $Q_{11}$ and $Q_{12}$ instead of the single p-channel MOS transistor $Q_1$ of Fig. 3. The gate electrode of each of the transistors $Q_{11}$ and $Q_{12}$ is connected to the drain electrode of the same one of the transistors $Q_{11}$ and $Q_{12}$, so that the series connection of two transistors $Q_{11}$ and $Q_{12}$ is turned on in the condition that the operating voltage $V_{DD}$ is equal to $2V_{THP}$, where $V_{THP}$ designates the threshold voltage of the p-channel MOS transistor $Q_{11}$ or $Q_{12}$. The turned-on resistance of the series connection of two transistors $Q_{11}$ and $Q_{12}$ is set to a value $R_1''$

which is, for example, approximately equal to the turned-on resistance $R_1'$ of the transistors $Q_1$ of Fig. 3.

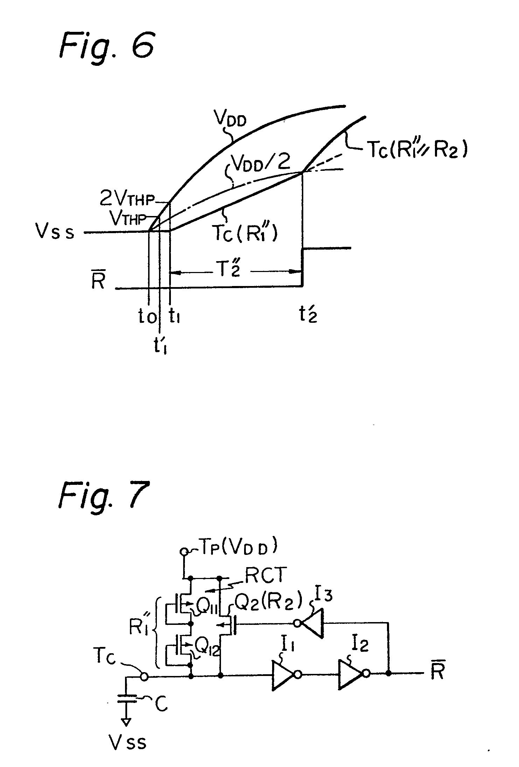

With reference to Fig. 6, operation of the power-on reset circuit of Fig. 5 will now be explained. Assume that the operating voltage $V_{DD}$ starts to rise from the time $t_0$ as shown in Fig. 6. At the time $t = t_1$ when the potential of the operating voltage $V_{DD}$ reaches to $2V_{THP}$, the potential of the clear signal terminal $T_c$ starts to rise with a time constant $R_1''$ C toward $V_{DD}$. At the time $t = t_2'$ when the potential of the clear signal terminal $T_c$ reaches $V_{DD}/2$, the potential of the output signal from the first inverter $I_1$ changes from high to low and the potential of reset signal $\bar{R}$ from the second inverter $I_2$ changes from low to high. Since the minimum operating voltage of the internal circuits is approximately equal to $2V_{THP}$ which is approximately equal to $2V_{TH}$ of Fig. 4, the reset of the internal circuits is effected within a time period $T_2''$ from the time $t_1$ when the potential of the operating voltage $V_{DD}$ reaches $2V_{THP}$ to the time $t_2'$ when the reset signal $\bar{R}$ changes from low level to high level. In the power-on reset circuit of Fig. 5, the time period $T_2''$ can be longer than that of the power-on reset circuit of Fig. 3, because the potential of the clear signal terminal $T_c$ starts to rise at the time $t = t_1$ which is later than the time $t_1'$ when the potential of the terminal $T_c$ of the power-on reset circuit of Fig. 3 starts to rise.

Fig. 7 illustrates still another power-on reset circuit as the third embodiment of the present invention. The power-on reset circuit of Fig. 7 is the same as that of Fig. 5, except that the power-on reset circuit of Fig. 7 further comprises the third inverter $I_3$ which inverts the reset signal $\bar{R}$ from the second inverter $I_2$ and applies the inverted signal to the gate electrode of the transistor $Q_2$. Since the potential of the output signal of the third inverter $I_3$ changes from high to low after the potential of the reset signal $\bar{R}$ has changed from low to high, i.e. after the time period $T_2''$ of Fig. 6 has finished, the power-on reset circuit of Fig. 7 can effect a more reliable reset of the internal circuits than the power-on reset circuit of Fig. 5.

In the above-mentioned embodiments, the capacitor C is disposed outside of the semiconductor chip and connected between the clear signal terminal $T_c$ of the semiconductor chip and the low potential voltage $V_{ss}$. However, it should be noted that the capacitor C can be formed on the semiconductor chip on which the power-on reset circuit and the internal circuits are formed, or, the substantial capacitance, for example, stray capacitance, existing between the clear signal terminal $T_c$ and the low potential voltage $V_{ss}$ can be used for forming the time constant circuit instead of the capacitance of the capacitor C.

As mentioned above, according to the present invention, it is not necessary to increase the capacitance of the capacitor C, so that the capacitor C does not occupy a large space, for example, in electronic equipment and the cost of the power-on reset circuit does not increase. The resistance of the resistance circuit of the power-on reset circuit according to the present invention is high only for a short time after the operating voltage is supplied to the power-on reset circuit and is low in steady state, so that the clear signal terminal $T_c$ is tightly pulled up to the operating voltage $V_{DD}$ and the operation of the power-on reset circuit is not affected by noise. Therefore, the power-on reset circuit according to the present invention is suitable, for example, for use in automobile equipment which receives severe electrical noise and whose size is limited.

**Claims**

1. A power-on reset circuit to reset internal circuits in a semiconductor device initially after an operating voltage is switched on, the power-on reset circuit comprising an operating voltage terminal (Tp) for the internal circuits, a capacitor (C), a detector means ($I_1$, $I_2$) for detecting a potential of one of the terminals (Tc) of the capacitor (C) and sending a reset signal to the internal circuits until the potential reaches a predetermined value after the operating voltage is switched on the operating voltage terminal (Tp) and a resistance circuit (RCT) connected between the one of the terminals (Tc) of the capacitor (C) and the operating voltage terminal (Tp) of the internal circuits, characterised in that the resistance value of the resistance circuit (RCT) decreases after the potential of the one of the terminals (Tc) of the capacitor (C) has reached the predetermined value.

2. A power-on reset circuit according to claim 1, further characterised in that the resistance circuit (RCT) comprises a first resistance element ($R'_1$) and a second resistance element ($R_2$) which is connected in parallel with the first resistance element ($R'_1$) and the resistance value of which decreases after the potential of the one of the terminals (Tc) of the capacitor (C) has reached the predetermined value.

3. A power-on reset circuit according to claim 2, further characterised in that the second resistance element ($R_2$) comprises a transistor ($Q_2$) connected between the operating voltage terminal (Tp) and the one of the terminals of the capacitor (C), the transistor ($Q_2$) being turned on after the potential of the one of the terminals (Tc) of the capacitor (C) reaches the predetermined value.

4. A power-on reset circuit according to claim 3, further characterised in that the detector means comprises an inverter ($I_1$) whose input terminal is connected to the one of the terminals (Tc) of the capacitor (C) the output signal of the inverter ($I_1$) changing between a high potential level and a low potential level when the potential of the one of the terminals (Tc) of the capacitor (C) reaches the predetermined value, the output signal of the inverter ($I_1$) also being supplied to the gate electrode of the transistor ($Q_2$) forming the second resistance element.

5. A power-on reset circuit according to claim 4, further characterised in that the detector means also comprises a second inverter ($I_2$) which inverts the output signal of the inverter ($I_1$) and the output signal of which is used as the reset signal to the internal circuits.

6. A power-on reset circuit according to claim 3, further characterised in that the detector means comprises a first inverter ($I_1$) whose input terminal is connected to the one of the terminals (Tc) of the capacitor (C), the output signal of the first inverter ($I_1$) changes between a high potential level and a low potential level when the potential of the one of the terminals (Tc) of the capacitor (C) reaches the predetermined value, a second inverter ($I_2$) which inverts the output signal of the first inverter ($I_1$) and the output signal of the second inverter ($I_2$) is used as the reset signal to the internal circuits, and a third inverter ($I_3$) which inverts the output signal of the second inverter ($I_2$), the output signal of the third inverter ($I_3$) being supplied to the gate electrode of the transistor ($Q_2$) forming the second resistance element ($R_2$).

7. A power-on reset circuit according to any one of the preceding claims, further characterised in that the first resistance element ($R_1'$) comprises a MOS transistor ($Q_1$) whose source electrode is connected to the operating voltage terminal (Tp) of the internal circuits and whose drain and gate electrodes are commonly connected to the one of the terminals (Tc) of the capacitor (C).

8. A power-on reset circuit according to any one of claims 2 to 6, further characterised in that the first resistance element ($R_1'$) comprises a MOS transistor ($Q_1$) whose source electrode is connected to the operating voltage terminal (Tp) of the internal circuits, whose drain electrode is connected to the one of the terminals (Tc) of the capacitor (C), and whose gate electrode is grounded.

9. A power-on reset circuit according to any one of claims 2 to 6, further characterised in that the first resistance element ($R_1$) comprises a resistor having a constant resistance.

10. A power-on reset circuit according to any one of claims 2 to 6, further characterised in that the first resistance element ($R_1''$) comprises a plurality of gate-drain connected MOS transistors ($Q_{11}$, $Q_{12}$) connected in series.

**Patentansprüche:**

1. Rückstellschaltung zur Rückstellung interner Kreise in einer Halbleitervorrichtung beim Einschalten der Betriebesspannung, mit einem Betriebsspannungsanschluß (Tp) für die in- ternen Kreise, einem Kondensator (C), einer Detektoreinrichtung ($I_1$, $I_2$) zum Erfassen eines Potentials eines der Anschlüsse (Tc) des Kondensators (C) und zur Aussendung eines Rückstellsignals zu den in-ternen Kreisen, bis das Potential einen vorbestimmten Wert erreicht, nachdem die Betriebsspannung an dem Betriebsspannungsanschluß (Tp) eingeschaltet worden ist, und mit einem Widerstandskreis (RCT), welcher zwischen dem einen der Anschlüsse (Tc) des Kondensators (C) und dem Betriebsspannungsanschluß (Tp) der internen Kreise geschaltet ist, dadurch gekennzeichnet, daß der Widerstandswert des Widerstandskreises (RCT) abfällt, nachdem das Potential des einen Anschlusses (Tc) des Kondensators (C) einen vorbestimmten Wert erreicht hat.

2. Rückstellschaltung nach Anspruch 1, dadurch gekennzeichnet, daß der Widerstandskreis (RCT) ein erstes Widerstandselement ($R_1'$) und ein zweites Widerstandselement ($R_2$) umfaßt, welches parallel zu dem ersten Widerstandselement ($R_1'$) geschaltet ist und dessen Widerstandswert abfällt, nachdem das Potential des einen der Anschlüsse (Tc) des Kondensators (C) einen vorbestimmten Wert erreicht hat.

3. Rückstellschaltung nach Anspruch 2, dadurch gekennzeichnet, daß das zweite Widerstandselement ($R_2$) einen Transistor ($Q_2$) umfaßt, welcher zwischen dem Betriebsspannungsanschluß (Tp) und dem einen der Anschlüsse des Kondensators (C) geschaltet ist, und daß der Transistor ($Q_2$) angeschaltet wird, nachdem das Potential des einen Anschlusses (Tc) des Kondensators (C) einen vorbestimmten Wert erreicht.

4. Rückstellschaltung nach Anspruch 3, dadurch gekennzeichnet, daß die Detektoreinrichtung einen Inverter ($I_1$) umfaßt, dessen Eingangsanschluß mit einem der Anschlüsse (Tc) des Kondensators (C) verbunden ist, daß das Ausgang-ssignal des Inverters ($I_1$) zwischen einem hohen Potentialpegel und einem niedrigen Potentialpegel wechselt, wenn das Potential des einen der Anschlüsse (Tc) des Kondensators (C) einen vorbestimmten Wert erreicht, und daß das Ausgangssignal des Inverters ($I_1$) ferner der Gateelektrode des Transistors ($Q_2$) zugeführt wird, welcher das zweite Widerstandselement bildet.

5. Rückstellschaltung nach Anspruch 4, dadurch gekennzeichnet, daß die Detektoreinrichtung ferner einen zweiten Inverter ($I_2$) umfaßt, welcher das Ausgangssignal des Inverters ($I_1$) invertiert und dessen Ausgangssignal als Rückstellsignal für die internen Kreise verwendet wird.

6. Rückstellchaltung nach Anspruch 3, dadurch gekennzeichnet, daß die Detektoreinrichtung einen ersten Inverter ($I_1$) umfaßt, dessen Eingangsanschluß mit dem einen der Anschlüsse (Tc) des Kondensators (C) verbunden ist, daß das Ausgangssignal des Inverters ($I_1$) zwischen einem hohen Potential-

pegel und einem niedrigen Potentialpegel wechselt, wenn das Potential des einen Anschlusses (Tc) des Kondensators (C) den vorbestimmten Wert erreicht, daß ein zweiter Inverter ($I_2$) vorgesehen ist, welcher das Ausgangssignal des ersten Inverters ($I_1$) invertiert und dessen Ausgangssignal als Rückstellsignal für die internen Kreise verwendet wird, und daß ein dritter Inverter ($I_3$) vorgesehen ist, welcher das Ausgangssignal des zweiten Inverters ($I_2$) invertiert und daß das Ausgangssignal des dritten Inverters ($I_3$) der Gateelektrode des Transistors ($Q_2$) zugeführt wird, welche das zweite Widerstandselement ($R_2$) bildet.

7. Rückstellschaltung nach einem der vorhergehenden Ansprüche, dadurch gekennzeichnet, daß das erste Widerstandselement ($R_1'$) einen MOS-Transistor ($Q_1$) umfaßt, dessen Sourceelektrode mit dem Betriebsspannungsanschluß (Tp) der internen Kreise und dessen Drain- und Gateelektroden gemeinsam mit dem einen der Anschlüsse (Tc) des Kondensators (C) verbunden sind.

8. Rückstellschaltung nach einem der Ansprüche 2 bis 6, dadurch gekennzeichnet, daß das erste Widerstandselement ($R_1'$) einen MOS-Transistor ($Q_1$) umfaßt, dessen Sourceelektrode mit dem Betriebsspannungsanschluß (Tp) der internen Kreise und dessen Drainelektrode mit dem einen der Anschlüsse (Tc) verbunden ist, und dessen Gateelektrode geerdet ist.

9. Rückstellschaltung nach einem der Ansprüche 2 bis 6, dadurch gekennzeichnet, daß das erste Widerstandselement ($R_1$) einen Widerstand mit einem festen Widerstandswert hat.

10. Rückstellschaltung nach einem der Ansprüche 2 bis 6, dadurch gekennzeichnet, daß das erste Widerstandselement ($R_1''$) eine Vielzahl von gate-drain-verbundenen MOS-Transistoren ($Q_{11}$, $Q_{12}$) umfaßt, welche in Reihe geschaltet sind.

## Revendications

1. Circuit de repositionnement activé lors de la mise sous tension afin de repositionner les circuits internes dans un dispositif semiconducteur lors d'une phase initiale après qu'une tension d'actionnement a été appliquée par manoeuvre d'un commutateur, le circuit de repositionnement activé lors de la mise sous tension comprenant une borne de tension d'actionnement (Tp) destinée aux circuits internes, un condensateur (C), un moyen détecteur ($I_1$, $I_2$) servant à détecter le potentiel de l'une des bornes (Tc) du condensateur (C) et à envoyer un signal de repositionnement aux circuits internes jusqu'à a que le potentiel atteigne une valeur prédéterminée après que la tension d'actionnement a été appliquée par manoeuvre d'un commutateur à la borne de tension d'actionnement (Tp), et un circuit de résistance (RCT) connecté entre la borne citée (Tc) du condensateur (C) et la borne de tension d'actionnement (Tp) des circuits internes, caractérisé en ce que la valeur de résistance du circuit de résistance (RCT) diminue après que le potentiel de la borne citée (Tc) du condensateur (C) a atteint la valeur prédéterminée.

2. Circuit de repositionnement activé lors de la mise sous tension selon la revendication 1, caractérisé en outre en ce que le circuit de résistance (RCT) comprend un premier élément de résistance ($R_1'$) et un deuxième élément de résistance ($R_2$) qui est connecté en parallèle avec le premier élément de résistance ($R_1'$) et dont la valeur de resistance diminue après que le potentiel de la borne citée (Tc) du condensateur (C) a atteint la valeur prédéterminée.

3. Circuit de repositionnement activé lors de la mise sous tension selon la revendication 2, caractérisé en outre en ce que le deuxième élément de résistance ($R_2$) comprend un transistor ($Q_2$) connecté entre la borne de tension d'actionnement (Tp) et la borne citée du condensateur (C), le transistor ($Q_2$) devenant conducteur après que le potentiel de la borne citée (Tc) du condensateur (C) a atteint la valeur prédéterminée.

4. Circuit de repositionnement activé lors de la mise sous tension selon la revendication 3, caractérisé en outre en ce que le moyen détecteur comprend un inverseur ($I_1$) dont la borne d'entrée est connecte à la borne citée (Tc) du condensateur (C), le signal de sortie de l'inverseur ($I_1$) variant entre un niveau de potentiel haut et un niveau de potentiel bas lorsque le potentiel de la borne citée (Tc) de condensateur (C) atteint la valeur prédéterminée, le signal de sortie de l'inverseur ($I_1$) étant également délivré à l'électrode de grille du transistor ($Q_2$) formant le deuxième élément de résistance.

5. Circuit de repositionnement activé lors de la mise sous tension selon la revendication 4, caractérisé en outre en ce que le moyen détecteur comprend également un deuxième inverseur ($I_2$) qui inverse le signal de sortie de l'inverseur ($I_1$) et dont le signal de sortie est utilisé comme signal de repositionnement destiné aux circuits internes.

6. Circuit de repositionnement activé lors de la mise sous tension selon la revendication 3, caractérisé en outre en ce que le moyen détecteur comprend un premier inverseur ($I_1$) dont la borne d'entrée est connectée à la borne citée (Tc) du condensateur (C), le signal de sortie du premier inverseur ($I_1$) varie entre un niveau de potentiel haut et un niveau de potentiel bas lorsque le potentiel de la borne citée (Tc) du condensateur (C) atteint la valeur prédéterminée, un deuxième inverseur ($I_2$) qui inverse le signal de sortie du premier inverseur ($I_1$) et le signal de sortie du deuxième inverseur ($I_2$) est utilisé comme signal de repositionnement à destination des circuits internes, et un troisième inverseur ($I_3$) qui

inverse le signal de sortie du deuxième inverseur ($I_2$), le signal de sortie du troisième inverseur ($I_3$) étant délivré à l'électrode de grille du transistor ($Q_2$) formant le deuxième élément de résistance ($R_2$).

7. Circuit de repositionnement activé lors de la mise sous tension selon l'une quelconque des précédentes revendications, caractérisé en outre en ce que le premier élément de résistance ($R_1'$) comprend un transistor MOS ($Q_1$) dont l'électrode de source est connectée à la borne de tension d'actionnement (Tp) des circuits internes et dont les électrodes de drain et de grille sont connectées en commun à borne citée (Tc) du condensateur (C).

8. Circuit le repositionnement activé lors de la mise sous tension selon l'une quelconque des revendications 2 à 6, caractérisé en outre en ce que le premier élément de resistance ($R_1'$) comprend un transistor MOS ($Q_1$) dont l'électrode de source est connectée à la borne de tension d'actionnement (Tp) des circuits internes, dont l'électrode de brain est connectée à la borne citée (Tc) du condensateur (C), et dont l'électrode de grille est connectée à la terre.

9. Circuit de repositionnement activé lors de la mise sous tension selon l'une quelconque des revendications 2 à 6, caractérisé en outre en ce que le premier élément de résistance ($R_1$) comprend une résistance possédant une valeur constante.

10. Circuit de repositionnement activé lors de la mise sous tension selon l'une quelconque des revendications 2 à 6, caractérisé en outre en ce que le premier élément de résistance ($R_1''$) comprend plusieurs transistors MOS connectés grille-drain ($Q_{11}$, $Q_{12}$) connectés en série.

## Fig. IA

## Fig. IB

## Fig. 2A

## Fig. 2B

## Fig. 3

## Fig. 4

## Fig. 5

# Fig. 6

# Fig. 7